# EUROPÄISCHE PATENTANMELDUNG

(11) **EP 0 833 406 A2**
(43) Veröffentlichungstag der Anmeldung: **01.04.1998**
(21) Anmeldenummer: 97115370.5
(22) Anmeldetag: 04.09.1997
(51) Int. Cl.: H01R 9/09

(54) **Einpressstift mit einem elastischen Einpressbereich**

(30) Priorität: 26.09.1996 DE 19639688
(71) Anmelder: SIEMENS AKTIENGESELLSCHAFT, 80333 München (DE)
(72) Erfinder: Murr, Alfred, / (DE); Metzger, Rolf, 81477 München (DE); Wagner, Alexander, 67354 Römerberg (DE)

(57) **Zusammenfassung**

Der elastische, im Querschnitt bogenförmige Einpreßbereich (4) des Einpreßstiftes (1) ist an zwei Längsseiten (6, 7)an einander gegenüberliegenden Stellen mit seitlichen Verbreiterungen (8, 9) ausgebildet und liegt im eingepreßten Zustand nur mit diesen Verbreiterungen, nicht aber mit dem Bogenabschnitt (5) an einer Bohrungswandung (15) an. Ein derartiger Einpreßstift hat ein sehr gutes Federungsverhalten und wird praktisch nur elastisch verformt.

## Beschreibung

Die Erfindung betrifft einen Einpreßstift mit einem elastischen, im Querschnitt bogenförmigen Einpreßbereich für eine lötfreie, mechanische und/oder elektrische Verbindung in einer Bohrung einer plattenförmigen Unterlage, insbesondere zum Herstellen einer lötfreien Verbindung mit einer metallisierten oder durchkontaktierten Bohrung einer Leiterplatte.

Derartige Einpreßstifte sind in vielen Varianten mit elastischen Einpreßzonen von unterschiedlicher Querschnittsform bekannt, wie zum Beispiel auch in der sogenannten Buchstaben-Einpreßtechnik mit im Querschnitt beispielsweise C-, H-, S- oder Z-förmiger elastischer Einpreßzone. Bei Einpreßstiften mit einem elastischen, im Querschnitt bogenförmigen Einpreßbereich ist dieser kreisbogenförmig, sichelförmig oder C-förmig ausgebildet. Der unter der Bezeichnung 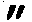 C-Press" bekanntgewordene, in der US-Patentschrift 4,017,143 gezeigte Einpreßstift hat eine elastische, im Querschnitt C-förmige Einpreßzone, die somit weitgehend an das Anschlußloch angepaßt ist und eine größtmögliche Berührungsfläche beider Teile ergibt, da die Einpreßzone über ihre gesamte Länge und den ganzen Außenumfang an der Wandung des Anschlußloches anliegt. Der C-Press-Stift erfordert relativ niedrige Einpreßkräfte und ist bei Mehrfacheinpressungen in das gleiche Loch öfter austauschbar als andere Stifte. Ferner sind auch C-Einpreßstifte bekannt, die nur an drei Stellen, d. h. an dem Scheitel und an den beiden Enden des Bogens, an der Wandung des Anschlußloches anliegen (Tri-C-Flex-Einpreßstift).

Bei Einpreßstiften mit elastischer Einpreßzone ergibt sich neben der elastischen auch eine plastische, bleibende Verformung des Einpreßbereiches. Flexible Einpreßstifte, d. h. Einpreßstifte mit elastischem Einpreßbereich, können zwar grundsätzlich mehrfach in das gleiche Loch eingesteckt werden, es hat sich aber herausgestellt, daß sich dabei das Elastizitätsverhalten verändert, d. h. die elastische Komponente reduziert sich mehr und mehr und der Einpreßbereich wird zunehmend plastisch verformt. Dadurch wird die Zuverlässigkeit der Einpreßverbindung beeinträchtigt und die Möglichkeit von Mehrfacheinpressungen stark eingeschränkt.

Der Erfindung liegt die Aufgabe zugrunde, bei einem Einpreßstift der eingangs genannten Art das Elastizitätsverhalten des flexiblen Einpreßbereiches zu verbessern.

Diese Aufgabe wird gemäß der Erfindung dadurch gelöst, daß der bogenförmige Einpreßbereich an zwei Längsseiten an einander gegenüberliegenden Stellen seitliche Verbreiterungen aufweist und im eingepreßten Zustand nur mit diesen Verbreiterungen an der Bohrungswandung anliegt.

Bei einem derartigen Einpreßstift ist der Einpreßbereich mit den seine normale Breite überragenden, einander gegenüberliegenden seitlichen Verbreiterungen so ausgebildet, daß er einerseits einen elastischen, im Querschnitt bogenförmigen Einpreßbereich aufweist, andererseits im eingepreßten Zustand aber nicht über die gesamte Länge des Einpreßbereiches an den beiden Enden des Bogens oder am gesamten Außenumfang des Bogens an der Bohrungswandung anliegt, sondern nur mit den Berührungspunkten der seitlichen Verbreiterungen mit der Bohrungswandung. Auf diese Weise wird ein sehr gutes Federungsverhalten des Einpreßbereiches erzielt, d. h. das Elastitzitätsverhalten des Einpreßbereiches verändert sich auch bei Mehrfacheinpressungen praktisch nicht, so daß sich eine fast ausschließlich elastische Verformung ergibt, die elastische Komponente der Verformung auch über längere Zeit und mehrfache Einpreßzyklen nahezu konstant bleibt und der Einpreßbereich praktisch kaum plastisch verformt wird. Dadurch wird eine hohe Zuverlässigkeit der Einpreßverbindung auch bei Mehrfacheinpressungen gewährleistet. Außerdem hat ein derartiger Einpreßstift noch den Vorteil, daß bei gutem Einlaufverhalten des Einpreßbereiches und relativ geringen Ein- und Auspreßkräften auch eine im allgemeinen genügend große Haltekraft erzielt wird.

Der erfindungsgemäße Einpreßstift ist auch für sehr kleine Ausführungen hervorragend geeignet und deshalb mit großem Vorteil bei Vielfach-Einpreßverbindungen mit geringem gegenseitigen Abstand, z. B. zur Einpreßbefestigung von Bausteinen, Bauelementen oder elektrischen Steckverbindern mit sehr kleinem Rastermaß, verwendbar.

Vorteilhafte Ausgestaltungen des Gegenstandes des Anspruches 1 sind in den Unteransprüchen angegeben.

Die Erfindung wird im folgenden anhand eines in der Zeichnung dargestellten Ausführungsbeispieles näher erläutert. Es zeigen
- Figur 1: einen Einpreßstift in Draufsicht,
- Figur 2: eine Seitenansicht II des Einpreßstiftes nach Figur 1,
- Figur 3: einen Querschnitt III-III durch den elastischen Einpreßbereich des Einpreßstiftes nach Figur 1,
- Figur 4: einen Querschnitt IV-IV durch den elastischen Einpreßbereich des Einpreßstiftes nach Figur 1,
- Figur 5: im Schnitt durch den Einpreßbereich den in eine Bohrung einer Unterlage eingesteckten Einpreßstift,
- Figur 6: einen Querschnitt VI-VI nach Figur 5 und
- Figur 7: den Einpreßstift in perspektivischer Darstellung.

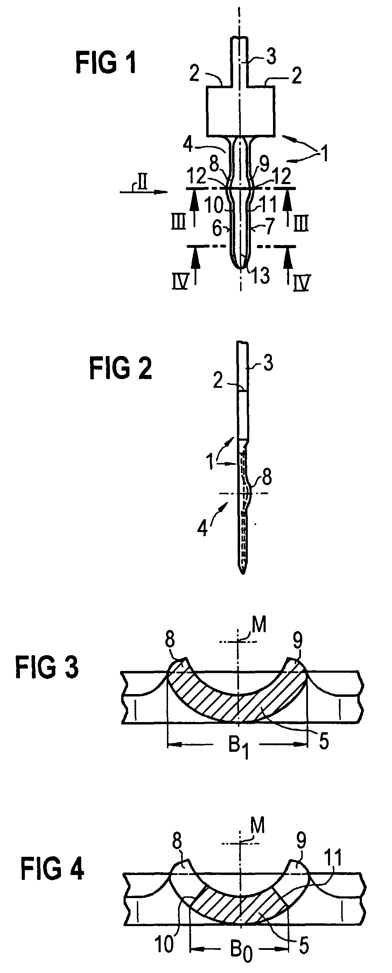

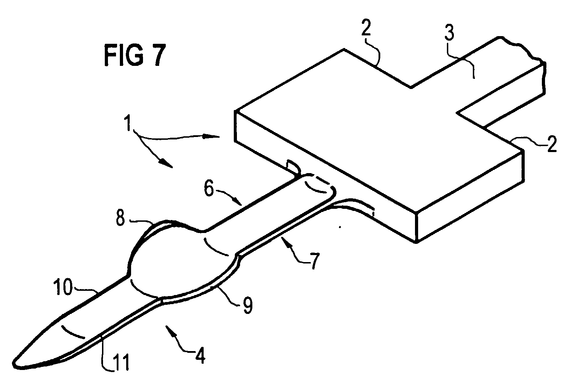

Der in den Figuren 1 und 2 sowie in Figur 7 dargestellte Einpreßstift 1 ist zum Einpressen in eine Bohrung einer plattenförmigen Unterlage mit Einpreßschultern 2 ausgebildet, an denen ein nicht dargestelltes Einpreßwerkzeug angreift. An der Seite der Einpreßschultern 2 weist der Einpreßstift 1 einen massiven Bereich 3 auf, der zum Beispiel als im Querschnitt rechteckigförmiger Stift ausgebildet ist und als solcher eine massive Einpreßzone oder auch einen massiven Anschluß- oder Kontaktbereich bildet. Als massive Einpreßzone dient der stiftförmige Bereich 3 zum Beispiel der Einpreßbefestigung eines elektrischen oder eines elektronischen Bauelements, welches seinerseits zum Beispiel auf einer Leiterplatte angeordnet und über die elastische Einpreßbefestigung an einer externen weiteren Leiterplatte befestigt werden kann. Als massiver Anschluß- oder Kontaktbereich kann der stiftförmige Bereich 3 als Kontaktstift zum Beispiel eines elektrischen Steckverbinders, insbesondere bei einer Messerleiste, dienen. Anstelle eines massiven Bereiches kann im Falle der Verwendung als Kontaktelement der Bereich 3 aber auch als buchsenförmiges Kontaktelement ausgebildet sein und dann eine Kontaktfeder einer vielpoligen Federleiste bilden. An dem anderen Ende, also an der den Einpreßschultern 2 gegenüberliegenden Seite, weist der Einpreßstift einen elastischen, im Querschnitt bogenförmigen Einpreßbereich 4 auf, der beim dargestellten Ausführungsbeispiel im Querschnitt die Form eines Kreisbogenabschnittes 5 mit dem Kreismittelpunkt M hat, wobei der Bogenabschnitt 5 hier kleiner als ein C etwa sichelförmig ausgebildet ist. Die Querschnittsform des Einpreßbereiches 4 ist deutlich sichtbar aus der Schnittdarstellung nach Figur 4, wobei die maximale Breite des Einpreßbereiches 4, d. h. die normale Breite des Einpreßbereiches über seine gesamte Länge mit B₀ bezeichnet und bei sehr kleinen Einpreßstiften beispielsweise etwa 0,3 mm ist. Ferner ist der Einpreßbereich 4 an seinem freien Ende verjüngt, um ein gutes Einlaufverhalten des Einpreßstiftes zu gewährleisten.

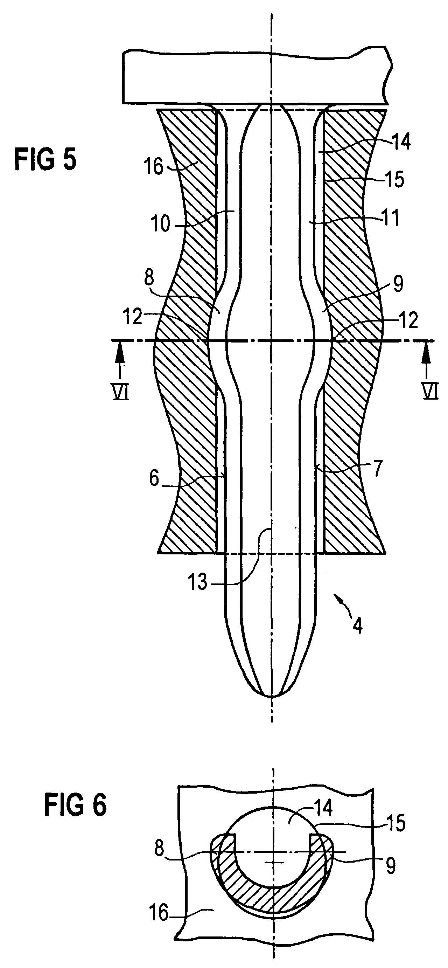

Das wesentliche Merkmal des erfindungsgemäßen Einpreßstiftes 1 ist darin zu sehen, daß der bogenförmige Einpreßbereich 4 an zwei Längsseiten 6 und 7 an einander gegenüberliegenden Stellen seitliche Verbreiterungen 8 und 9 aufweist. Diese Verbreiterungen sind hier als an den Längskanten 10 und 11 des bogenförmigen Abschnittes 5, d. h. im Querschnitt an den Enden des Bogens, vorgesehene Ansätze ausgebildet, welche sich in der Krümmung des bogenförmigen Abschnittes 5 verlaufend fortsetzen und sich in Längsrichtung des Einpreßbereiches 4 erstrecken, wobei sich die die seitlichen Verbreiterungen 8 und 9 bildenden Ansätze in Längsrichtung des Einpreßbereiches 4 zunehmend verbreitern, an einem Scheitel 12 bogenförmig abgerundet sind und sich dann nach diesem Scheitel in Längsrichtung des Einpreßbereiches zu dessen freiem Ende hin wieder verschmälern. Wie insbesondere den Figuren 1 und 5 deutlich zu entnehmen ist, sind die seitlichen Verbreiterungen 8 und 9 symmetrisch in bezug auf die Längsmittelachse 13 des Einpreßbereiches angeordnet und ausgebildet, wobei der Einpreßbereich an der Stelle der seitlichen Verbreiterungen 8 und 9, d. h. genau an der Stelle des Scheitels 12, eine in Figur 3 mit B₁ bezeichnete maximale Breite aufweist. Diese Breite B₁ kann bei sehr kleinen Einpreßstiften mit einer Breite B₀ von etwa 0,3 mm z. B. etwa 0,4 mm sein. Diese Maße sind lediglich beispielhafte Angaben für sehr kleine Einpreßstifte, verdeutlichen aber, daß ein derartiger Einpreßstift auch bei Vielfach-Einpreßverbindungen mit geringem gegenseitigen Abstand, also z. B. bei Einpreßbefestigungen mit sehr kleinem Rastermaß, verwendbar ist.

In den Figuren 5 und 6 ist eine Einpreßbefestigung im in eine plattenförmige Unterlage gesteckten Zustand dargestellt. Dabei kann es sich um eine Einpreßbefestigung in einer durchkontaktierten Bohrung 14 einer Leiterplatte 16 handeln. Die Figuren 5 und 6 zeigen stark vergrößert und damit sehr deutlich, daß der bogenförmige Einpreßbereich 4 im eingepreßten Zustand des Einpreßstiftes 1 nur mit den seitlichen Verbreiterungen 8 und 9, nicht aber mit den Längskanten 10 und 11 und dem Außenumfang des bogenförmigen Abschnittes 5 an der metallisierten Wandung 15 der Bohrung 14 anliegt, wobei die seitlichen Verbreiterungen 8 und 9 jeweils mit ihrem Scheitel 12 und den sich in Längsrichtung des Einpreßbereiches 4 an diesen Scheitel angrenzenden Bereichen geringfügig in die Bohrungswandung 15 eindringen.

Bei dem dargestellten Ausführungsbeispiel ist der Einpreßstift 1 im Verlaufe der Längsrichtung des Einpreßbereiches 4 an zwei einander gegenüberliegenden Stellen mit seitlichen Verbreiterungen 8 und 9 ausgebildet. Es ist aber auch möglich, den Einpreßbereich 4 zusätzlich zu diesen beiden seitlichen Verbreiterungen 8 und 9 an einer anderen Stelle oder ggf. an mehreren anderen Stellen im Verlaufe seiner Längsrichtung mit weiteren, einander gegenüberliegenden seitlichen Verbreiterungen auszubilden.

Der dargestellte Einpreßstift 1 ist in einem Stanz-Biege-Verfahren hergestellt, wobei die seitlichen Verbreiterungen bei dem Stanzvorgang gebildet werden und der Einpreßbereich 4 in einem Biegevorgang seinen bogenförmigen Querschnitt mit sich in der Bogenkrümmung fortsetzenden seitlichen Verbreiterungen erhält.

## Patentansprüche

1. Einpreßstift (1) mit einem elastischen, im Querschnitt bogenförmigen Einpreßbereich (4) für eine lötfreie, mechanische und/oder elektrische Verbindung in einer Bohrung einer plattenförmiger Unterlage, insbesondere zum Herstellen einer lötfreien Verbindung mit einer metallisierten oder durchkontaktierten Bohrung (14) einer Leiterplatte (16), **dadurch gekennzeichnet,** daß der bogenförmige Einpreßbereich (4) an zwei Längsseiten (6, 7) an einander gegenüberliegenden Stellen seitliche Verbreiterungen (8, 9) aufweist und im eingepreßten Zustand nur mit diesen Verbreiterungen (8, 9) an der Bohrungswandung (15) anliegt.

2. Einpreßstift nach Anspruch 1, **dadurch gekennzeichnet,** daß die seitlichen Verbreiterungen (8, 9) als an den Längskanten (10, 11) des bogenförmigen Abschnittes (5) des Einpreßbereiches (4), d. h. im Querschnitt an den Enden des Bogens vorgesehene, sich in Längsrichtung des Einpreßbereiches (4) erstreckende Ansätze ausgebildet sind.

3. Einpreßstift nach Anspruch 1 oder 2, **dadurch gekennzeichnet,** daß sich die seitlichen Verbreiterungen (8, 9) in der Krümmung des bogenförmigen Abschnittes (5) verlaufend fortsetzen.

4. Einpreßstift nach einem der Ansprüche 1 bis 3, **dadurch gekennzeichnet,** daß sich die seitlichen Verbreiterungen (8, 9) in Längsrichtung des Einpreßbereiches (4) zunehmend verbreitern, an einem Scheitel (12) bogenförmig abgerundet sind und sich nach dem Scheitel (12) in Längsrichtung des Einpreßbereiches (4) wieder verschmälern.

5. Einpreßstift nach einem der Ansprüche 1 bis 4, **dadurch gekennzeichnet,** daß die seitlichen Verbreiterungen (8, 9) symmetrisch in bezug auf die Längsmittelachse (13) des Einpreßbereiches (4) angeordnet und ausgebildet sind.

6. Einpreßstift nach einem der vorhergehenden Ansprüche, **dadurch gekennzeichnet,** daß der elastische Einpreßbereich (4) im Querschnitt eine maximale Breite B₀ von etwa 0,3 mm und an der Stelle der seitlichen Verbreiterungen (8, 9) eine maximale Breite B₁ von etwa 0,4 mm aufweist.

7. Einpreßstift nach einem der vorhergehenden Ansprüche, **dadurch gekennzeichnet,** daß der Einpreßstift (1) an einem Ende des elastischen Einpreßbereiches (4) mit Einpreßschultern (2) für ein Einpreßwerkzeug ausgebildet ist.

8. Einpreßstift nach einem der vorhergehenden Ansprüche, **dadurch gekennzeichnet,** daß der Einpreßstift (1) an seinem einen Ende mit seinem elastischen Einpreßbereich (4) und an seinem anderen Ende mit einem massiven Bereich (3), z. B. mit einer massiven Einpreßzone oder einem massiven Anschluß- oder Kontaktbereich ausgebildet ist.
